# EUROPÄISCHE PATENTSCHRIFT

(11) **EP 2 695 206 B1**
(45) Veröffentlichungstag und Bekanntmachung des Hinweises auf die Patenterteilung: **24.06.2020**
(21) Anmeldenummer: 12707060.5
(22) Anmeldetag: 23.02.2012
(51) Int. Cl.: H01L 31/18, H01L 31/061

(54) **VERFAHREN ZUR HERSTELLUNG EINER SOLARZELLE**
METHOD FOR PRODUCING A SOLAR CELL
PROCÉDÉ DE FABRICATION D'UNE CELLULE SOLAIRE

(30) Priorität: 01.04.2011 DE 102011006624
(43) Veröffentlichungstag der Anmeldung: 12.02.2014
(73) Patentinhaber: Robert Bosch GmbH, 70442 Stuttgart (DE)
(72) Erfinder: BOESCKE, Tim, 99096 Erfurt (DE)
(74) Vertreter: Isarpatent
(86) Internationale Anmeldenummer: PCT/EP2012/053041
(87) Internationale Veröffentlichungsnummer: WO 2012/130534

(56) Entgegenhaltungen:
- WO-A1-2007/059551
- WO-A2-2011/157422
- WO-A2-2012/080428
- US-B1- 6 429 037
- MACK S ET AL: "Towards 19% efficient industrial PERC devices using simultaneous front emitter and rear surface passivation by thermal oxidation", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20. Juni 2010 (2010-06-20), Seiten 34-38, XP031783873, ISBN: 978-1-4244-5890-5
- S. MACK ET AL.: "Simultaneous front emitter and rear surface passivation by thermal oxydation - An industrially feasible approach to a 19% efficient perc device", 25ND EUROPEAN PHOTOVOLTAIC SOLAR ENERGY CONFERENCE, PROCEEDINGS OF THE 25ND INTERNATIONAL CONFERENCE, WIP-RENEWABLE ENERGIES, 6. September 2010 (2010-09-06), Seiten 2218-2222, XP040531178, ISBN: 978-3-936338-26-3
- MATHAIS WEISS ET AL: "Selective Emitter from Structured Diffusion Source Proves its Capability of Industrial Realization", EUROPEAN PHOTOVOLTAIC SOLAR ENERGY CONFERENCE AND EXHIBITION (EU PVSEC),, 21. September 2009 (2009-09-21), Seiten 1941-1944, XP002657501, ISBN: 3-936338-25-6 [gefunden am 2009-09-21]
- RODER T ET AL: "0.4% absolute efficiency gain of industrial solar cells by laser doped selective emitter", 7. Juni 2009 (2009-06-07), PHOTOVOLTAIC SPECIALISTS CONFERENCE (PVSC), 2009 34TH IEEE, IEEE, PISCATAWAY, NJ, USA, PAGE(S) 871 - 873, XP031626438, ISBN: 978-1-4244-2949-3 Seiten 871-873, in der Anmeldung erwähnt Zusammenfassung Seite 872, linke Spalte, Absatz 1 Abbildung 1
- JAEGER U ET AL: "Selective emitter by laser doping from phosphosilicate glass", EUROPEAN PHOTOVOLTAIC SOLAR ENERGY CONFERENCE AND EXHIBITION (EU PVSEC),, Bd. 24, 1. September 2009 (2009-09-01), Seiten 1740-1743, XP008144094, ISBN: 3-936338-25-6

## Beschreibung

Die Erfindung betrifft ein Verfahren zur Herstellung einer Solarzelle mit einem Substrat aus kristallinem Silizium, wobei in einer Oberfläche des Si-Substrats ein lokal definierter n-dotierter Emitterbereich durch Eindotieren/Eintreiben von Phosphor(P)-Atomen aus einem P-haltigen Belag in das Substrat gebildet wird.

### Stand der Technik

Im Rahmen der sich in den letzten Jahren explosionsartig entwickelnden großtechnischen Nutzung der Photovoltaik als alternative Methode der Stromerzeugung haben Solarzellen auf Basis von kristallinem Silizium nach wie vor herausragende Bedeutung. Dies ist primär durch ihren hohen Wirkungsgrad, aber auch durch die nachgewiesene lange Betriebsdauer mit hoher Ausbeute sowie durch die etablierte und hochproduktive Technologie zu deren Herstellung bedingt.

Dennoch zwingen der Wettbewerb mit anderen Methoden der Stromerzeugung und die volkswirtschaftlich gebotene dramatische Reduzierung der Subventionen die Hersteller zu ständigen Kostensenkungen. Da das Kostensenkungspotential auf der Materialseite begrenzt ist, wird nach Möglichkeiten zur Effizienzsteigerung im Herstellungsprozess der Solarzellen sowie in den nachgelagerten Schritten der Bildung von Solarmodulen und -paneelen gesucht.

Bei Solarzellen mit einkristallinem Si-Substrat (speziell auf Basis von CZ-Silizium) haben sich selektiv dotierte Emitter mit fingerartiger Struktur etabliert, die speziell durch Phosphordotierung gebildet werden.

Bei der Anmelderin wurde ein Prozessfluss zur Herstellung von Solarzellen mit selektivem Emitter nach dem Konzept der "strukturierten" Quelle entwickelt (s. weiter unten; Tabelle 1A). In diesem Prozessfluss wird zunächst der Wafer mit Phosphorglas (PSG) belegt, welches anschließend per Tintenstrahl (Injekt)-Druck mit einem Wachs maskiert und nasschemisch in den Zwischenfingergebieten entfernt wird. Nach Entfernen der Wachsmaskierung findet in einer Sauerstoffatmosphäre ein zweiter Eintreibschritt statt, durch den die Dotierung in den Zwischenfingergebieten tief eingetrieben und zugleich die Oberflächenkonzentration abgesenkt wird. Da sich zum Zeitpunkt des Eintreibens in diesen Gebieten kein Phosphorglas befindet, wächst ein relativ reines Oxid auf, welches in einem SiO/SiN-Stack zur Passivierung verwendet werden kann.

Durch die Kombination eines tief eingetriebenen Emitters mit guter Oxidpassivierung lassen sich sehr niedrige Emittersättigungsströme und eine gute Blauempfindlichkeit des Emitters erreichen. Ein Nachteil dieses Verfahrens besteht in den hohen Kosten der Inkjet-Maskierung. Dieses liegt im Materialverbrauch (Wachs), und der Notwendigkeit eines separaten Nassschrittes zur Wachsentfernung begründet.

Ein alternatives Verfahren besteht in der Anwendung von Laserdotierung gemäß T. C. Röder, P. Grabitz, S. J. Eisele, J. R. Köhler, and J. H. Werner, "0,4 % Absolute Efficiency Gain of Industrial Solar Cells by Laser Doped Selective Emitter", 34th Photovoltaic Specialists Conf, edited by: IEEE Publishing Service, Piscataway, NY (2009), mit einer einstufigen Diffusion (s. weiter unten; Tabelle 1B). Hier wird durch eine PSG-Belegung mit anschließender Diffusion zunächst eine relative hochohmige flache Diffusion hergestellt. Anschließend wird mit Hilfe eines Lasers im Fingerbereich das Silizium bis zu einer Tiefe von einigen 100 nm aufgeschmolzen, wodurch eine größere Menge Phosphor aus dem vorhandenen PSG in das Substrat eindringen kann.

Dieses Verfahren ist deutlicher weniger kostenintensiv als das oben erläuterte Konzept der "strukturierten" Quelle unter Einsatz eines Tintenstrahl-Druckverfahrens, da für die Strukturierung kein Resist benötigt wird und nur ein Hochtemperaturschritt. Nachteilig ist jedoch, dass durch die einstufige Diffusion nur ein qualitativ schlechterer Emitter erzeugt werden kann. Dies liegt darin begründet, dass keine tiefe Diffusion erreicht werden kann, da die Oberfläche mit hochdotiertem PSG belegt bleiben muss. Ebenso kann das hochdotierte PSG nicht zur Passivierung genutzt werden, so dass die Passivierung mit qualitativ schlechterem SiN erfolgen muss. Ein weiteres Problem besteht in Kristalldefekten im laserdotierten Bereich, welche die Rekombination im metallisierten Gebiet erhöhen.

Die beiden vorgenannten Konzepte sind in der nachfolgenden tabellarischen Zusammenstellung (Tabelle 1A und 1B) kurz verdeutlicht:

**Tabelle 1A: Strukturierte Quelle, mit Inkjet-Verfahen erzeugt**

| | |
|---|---|
| 1 | Textur |
| 2 | Belegen mit POCl₃ |
| 3 | Drucken des Fingerbereiches |
| 4 | PSG Ätzung (HF) |
| 5 | Strip des Injekt Resists |
| 6 | Eintreiben des Emitters (O2) |
| 7 | Oxidätzung |
| 8 | PECVD Nitrid VS |
| 9 | Drucken |
| 10 | Feuern |

**Tabelle 1B: Laserdoping nach Emitterdiffusion**

| | |
|---|---|
| 1 | Textur |
| 2 | Shallow Emitter Diffusion (POCl₃) |
| 3 | Laserdotierung im Fingergebiet |
| 4 | PSG Ätzung (HF) |
| 5 | PECVD Nitrid VS |
| 6 | Feuern |

Die Druckschrift MACK S ET AL: "Towards 19% efficient industrial PERC devices using simultaneous front emitter and rear surface passivation by thermal oxidation", 20. Juni 2010 beschreibt ein Verfahren zur Herstellung einer Solarzelle mit einem Substrat aus kristallinem Silizium, wobei in einer Oberfläche des Si-Substrats ein lokal definierter n-dotierter Emitterbereich durch Eindotieren/Eintreiben von Phosphor(P)-Atomen aus einem P-haltigen Belag in das Substrat gebildet wird. In dieser Druckschrift wird eine dünne Oxidschicht ausgebildet und eine SiNₓ-Schicht wird direkt auf die ausgebildeten Oxidschicht abgeschieden.

Die Druckschrift S. MACK ET AL.: "Simultaneous front emitter and rear surface passivation by thermal oxydation - An industrially feasible approach to a 19% efficient perc device", 6. September 2010 betrifft ein Verfahren zur Herstellung einer Solarzelle mit einem Substrat aus kristallinem Silizium, wobei in einer Oberfläche des Si-Substrats ein lokal definierter n-dotierter Emitterbereich durch Eindotieren/Eintreiben von Phosphor(P)-Atomen aus einem P-haltigen Belag in das Substrat gebildet wird. In dieser Druckschrift wird eine Oxidschicht mit einer Dicke von 10 nm ausgebildet und eine SiNₓ-Schicht wird direkt auf die ausgebildeten Oxidschicht abgeschieden. In einer zweiten Variante wird die Oxidschicht vollständig abgeätzt und durch eine SiNₓ-Schicht ersetzt werden.

### Offenbarung der Erfindung

Mit der vorliegenden Erfindung wird ein Verfahren mit den Merkmalen des Anspruchs 1 vorgeschlagen. Zweckmäßige Fortbildungen dieser Erfindung sind Gegenstand der abhängigen Ansprüche.

Das vorgeschlagene Verfahren umfasst ein vollflächiges Belegen der Oberfläche mit einem phosphorhaltigen Belag, z. B. durch einen POCl₃-Prozess. Hierauf folgt eine lokale Eindotierung von P-Atomen aus diesem Belag in das Si-Substrat, gemäß einer vorbestimmten geometrischen Konfiguration eines selektiven Emitters. Dieses Eindotieren erfolgt gemäß einem weiteren Teilgedanken der Erfindung mittels eines gesteuert über den Belag geführten Laserstrahls. Gemäß einem weiteren Teilgedanken der Erfindung wird anschließend ein Eintreiben der P-Dotierung in das Substrat auf thermischem Wege ausgeführt. Bei diesem Schritt liegen die Temperaturen speziell bei 750 °C bis 1000°C.

In einer Ausführung der Erfindung wird der Emitterbereich durch Koordinatensteuerung des Laserstrahls relativ zur Substratoberfläche, insbesondere als Fingerstruktur, lokal definiert. Es versteht sich, dass hierbei der Laserstrahl oder das Substrat oder beide bewegt werden können, und zwar mit Parametern, die sich aus der P-Konzentration im Belag und dem gewünschten Dotierungsprofil einerseits und den relevanten Parametern der Laserstrahlung (insbesondere deren mittlerer Leistung) andererseits ableiten lassen.

Die erfindungsgemäße Verfahrensführung erlaubt es in einer Ausführung, die P-Konzentration im Belag (Phosphorglas) relativ hoch einzustellen, so dass durch den Schritt des Laserdotierens eine relativ große Dotierungskonzentration in relativ kurzer Prozesszeit erzielt werden kann.

In einer weiteren Ausführung der Erfindung wird der Schritt des thermischen Einreibens der P-Atome derart ausgeführt, dass der im Schritt der Laserstrahl-Eindotierung lokal definierte Eindotierungs-Bereich lateral verbreitert wird.

Im erfindungsgemäßen Verfahren wird im Schritt des thermischen Eintreibens der P-Atome eine dicke Oxidschicht mit einer Höhe von 5 nm bis 100 nm auf der Substratoberfläche ausgebildet und ein Teil von deren Dicke zur Oberflächenpassivierung dort belassen, indem ein Teil der Dicke der Oxidschicht abgeätzt wird. Eine SiNₓ-Schicht wird auf die verbleibende Dicke der Oxidschicht abgeschieden.

Die nachstehende Tabelle gibt eine knappe Darstellung der relevanten Prozessschritte in ähnlicher Weise wie die obigen Tabellen 1A und 1B.

**Tabelle 1C: Strukturierte Quelle mit Laserdoping**

| | |
|---|---|
| 1 | Textur |
| 2 | Belegung mit Phosphorsilikatglas durch POCl₃-Prozess |
| 3 | Laserdotierung im Fingergebiet |
| 4 | PSG Ätzung (HF) |
| 5 | Eintreiben des Emitters (O2) |
| 6 | Oxidätzung (optional) |
| 7 | PECVD Nitrid VS |
| 8 | Drucken |
| 9 | Feuern |

### Zeichnungen

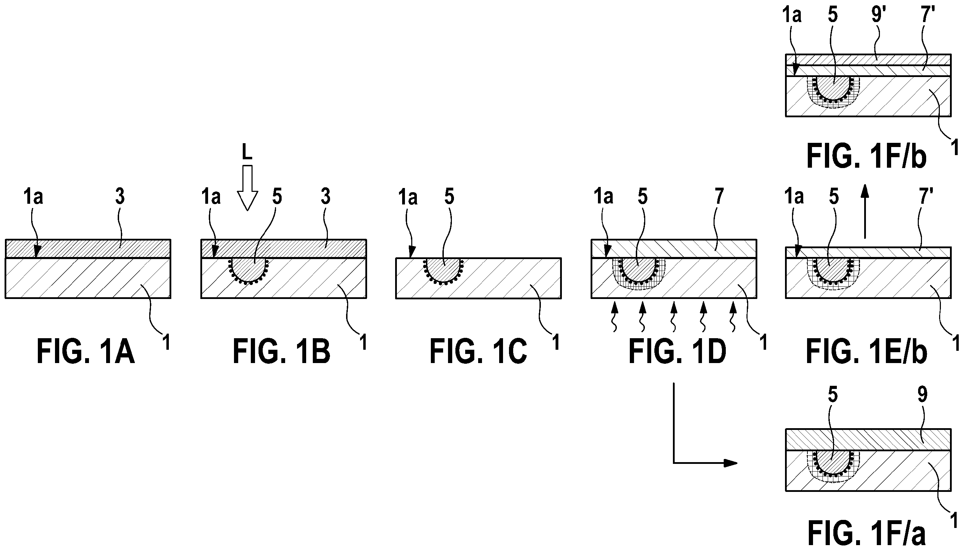

Vorteile und Zweckmäßigkeiten der Erfindung ergeben sich im Übrigen aus der nachfolgenden Beschreibung eines Ausführungsbeispiels des erfindungsgemäßen Verfahrens anhand der Figuren 1A bis 1F/b, bei denen es sich um schematische Querschnittsdarstellungen (Detailansichten) eines oberflächennahen Bereiches eines Si-Substrates in verschiedenen Schritten eines Herstellungsprozesses einer Solarzelle handelt.

Fig. 1 A zeigt eine Prozessstufe, bei der auf einer ersten Oberfläche **la** (die später im Gebrauchszustand der Solarzelle deren Vorderseite entsprechen wird) eines Si-Solarzellensubstrats **1** ein phosphorhaltiger Belag (Phosphorglas) **3** angeordnet ist. Gemäß Fig. 1B wirkt auf den phosphorhaltigen Belag **3** lokal Laserstrahlung **L** ein, durch die ein P-Dotierungsbereich **5** erzeugt wird, der sich von der Oberfläche **la** in die Tiefe des Substrats hinein erstreckt. Nach Erzeugung des Dotierungsbereiches **5** wird das Phosphorglas **3** von der gesamten Oberfläche **la** wieder entfernt, wodurch der in Fig. 1C gezeigte Zustand herausgebildet wird.

Anschließend wird in einem (durch gewellte Pfeile symbolisierten) thermischen Behandlungsschritt bevorzugt bei 750 °C bis 1000 °C ein Eintreiben der P-Dotierung in das Substrat **1**, ausgehend vom Dotierungsbereich **5,** ausgeführt. Hierbei wächst auf die Oberfläche **la** ein dickes ("thermisches") Oxid SiOₓ auf, das hier mit Ziffer **7** bezeichnet ist. In einem nicht erfindungsgemäßen Beispiel kann dieses thermische Oxid vollständig abgeätzt und durch eine als Antireflexschicht dienende SiNₓ-Schicht **9** ersetzt werden (vgl. Fig. 1F/a). Im erfindungsgemäßen Verfahren wird die Oxidschicht **7** nur zurückgeätzt, so dass eine planarisierte Rest-Oxidschicht **7'** bestehen bleibt (vgl. Fig. 1E/b). Anschließend wird auf diese Rest-Oxidschicht **7'** eine - gegenüber dem Beispiel dünnere - Nitridschicht **9'** aufgebracht.

Es wird darauf hingewiesen, dass weitere wesentliche Verfahrensschritte der Herstellung einer Solarzelle, wie das Aufbringen von korrespondierend zu den Dotierungsbereichen **5** angeordneten Kontaktbereichen ("Kontaktfingern") auf der Solarzellen-Vorderseite **1a** mittels Siebdruck oder das Anbringen und Feuern einer Rückseitenmetallisierung auf der (in den Figuren nicht dargestellten) Solarzellen-Rückseite, in den Figuren nicht dargestellt und in der zugehörigen Beschreibung nicht weiter erläutert sind. Diese Schritte werden in einer dem Fachmann bekannten Weise ausgeführt.

Im Übrigen ist die Ausführung der Erfindung nicht auf das vorstehend beschriebene Beispiel und die weiter oben hervorgehobenen Aspekte der Erfindung beschränkt, sondern ebenso in einer Vielzahl von Abwandlungen möglich, die im Rahmen fachgemäßen Handelns liegen.

## Patentansprüche

1. Verfahren zur Herstellung einer Solarzelle mit einem Substrat (1) aus kristallinem Silizium, bei dem zum Erzeugen eines lokal definierten, n-dotierten Emitterbereichs der Solarzelle die folgenden Schritte nacheinander durchgeführt werden:
vollflächiges Belegen einer für den Emitterbereich vorgesehenen Oberfläche (1a) des Silizium-Substrats (1) mit einem phosphorhaltigen Belag (3);
Erzeugen von lokal definierten Dotierungsbereichen (5) durch lokales Laserstrahl-Eindotieren von Phosphor-Atomen aus dem phosphorhaltigen Belag (3) gemäß einer vorbestimmten geometrischen Konfiguration;
Ablösen des phosphorhaltigen Belags (3) von der Oberfläche des Silizium-Substrats (1);
thermisches Eintreiben der in den Dotierungsbereichen (5) eindotierten Phosphor-Atome zur Ausbildung des lokal definierten, n-dotierten Emitterbereichs der Solarzelle mit gleichzeitigem Ausbilden einer Oxidschicht (7) mit einer Dicke im Bereich von 5 nm bis 100 nm auf der Oberfläche (1a);
Abätzen wenigstens eines Teils der Dicke der Oxidschicht (7), wobei ein Teil von der Dicke der ausgebildeten Oxidschicht (7) zur Oberflächenpassivierung belassen wird, indem lediglich ein Teil der Dicke der erzeugten Oxidschicht (7) abgeätzt wird;
Abscheiden einer SiNx-Schicht (9, 9') auf der Seite der für den Emitterbereich vorgesehenen Oberfläche (1a) des Silizium-Substrats (1), wobei die SiNx-Schicht (9') auf die zur Oberflächenpassivierung belassene Oxidschicht (7) abgeschieden wird.

2. Verfahren nach Anspruch 1,
wobei der Emitterbereich durch Koordinatensteuerung des Laserstrahls (L) relativ zur Oberfläche des Silizium-Substrats lokal definiert wird.

3. Verfahren nach Anspruch 2,
wobei der Emitterbereich als Fingerstruktur lokal definiert wird.

4. Verfahren nach einem der Ansprüche 2 oder 3,
wobei die Koordinatensteuerung abhängig von Parametern, die sich aus der Phosphor-Konzentration im phosphorhaltigen Belag (3) und dem gewünschten Dotierungsprofil des Dotierungsbereichs (5) ableiten lassen, erfolgt.

5. Verfahren nach einem der vorangehenden Ansprüche,
wobei die lokal definierten Dotierungsbereiche (5) gemäß einer vorbestimmten geometrischen Konfiguration eines selektiven Emitters erzeugt werden.

6. Verfahren nach einem der vorangehenden Ansprüche,
wobei der Schritt des thermischen Eintreibens der Phosphor-Atome derart ausgeführt wird, dass der erzeugte Dotierungsbereich vergrößert wird.

7. Verfahren nach Anspruch 6,
wobei der beim thermischen Eintreiben der Phosphor-Atome erzeugte Dotierungsbereich lateral verbreitert wird.

8. Verfahren nach einem der vorangehenden Ansprüche,
wobei der phosphorhaltige Belag Phosphorglas ist.

9. Verfahren nach einem der vorangehenden Ansprüche,
wobei der phosphorhaltige Belag durch einen POCl₃-Prozess erzeugt wird.

## Claims

1. Method for producing a solar cell, comprising a substrate (1) of crystalline silicon, in which, to produce a locally defined n-doped emitter region of the solar cell, the following steps are carried out in succession:
covering a surface (la), provided for the emitter region, of the silicon substrate (1) with a phosphorus-containing covering (3) over the entire area;
producing locally defined doping regions (5) by doping phosphorus atoms in locally from the phosphorus-containing covering (3) by laser beam, in a predetermined geometric configuration;
removing the phosphorus-containing covering (3) from the surface of the silicon substrate (1);
thermally collecting the phosphorus atoms doped into the doping regions (5) to form the locally defined n-doped emitter region of the solar cell, with simultaneous formation of an oxide layer (7) having a thickness in the range of 5 nm to 100 nm on the surface (la);
etching away at least part of the thickness of the oxide layer (7), part of the thickness of the formed oxide layer (7) being left for surface passivation in that only part of the thickness of the produced oxide layer (7) is etched away;
depositing an SiNx layer (9, 9') on the side of the surface (la), provided for the emitter region, of the silicon substrate (1), the SiNx layer (9') being deposited on the oxide layer (7) which was left for surface passivation.

2. Method according to claim 1,
wherein the emitter region is defined locally by coordinate control of the laser beam (L) relative to the surface of the silicon substrate.

3. Method according to claim 2,
wherein the emitter region is defined locally as a finger structure.

4. Method according to either claim 2 or claim 3,
wherein the coordinate control takes place as a function of parameters, which are derivable from the phosphorus concentration in the phosphorus-containing covering (3) and the desired doping profile of the doping region (5).

5. Method according to any of the preceding claims,
wherein the locally defined doping regions (5) are produced in accordance with a predetermined geometric configuration of a selective emitter.

6. Method according to any of the preceding claims,
wherein the step of thermally collecting the phosphorus atoms is carried out in such a way that the produced doping region is enlarged.

7. Method according to claim 6,
wherein the doping region produced by thermally collecting the phosphorus atoms is widened laterally.

8. Method according to any of the preceding claims,
wherein the phosphorus-containing covering is phosphosilicate glass.

9. Method according to any of the preceding claims,
wherein the phosphorus-containing covering is produced by a POCl₃ process.

## Revendications

1. Procédé de fabrication d'une cellule solaire comportant un substrat (1) de silicium cristallin, dans lequel afin de produire un domaine émetteur dopé n localement défini de la cellule solaire, les étapes suivantes sont effectuées successivement :
revêtement intégral d'une surface (la) du substrat de silicium (1) prévue pour le domaine émetteur avec un revêtement phosphoré (3) ;
production de domaines de dopage (5) localement définis par dopage au laser avec des atomes de phosphore provenant du revêtement phosphoré (3) conformément à une configuration géométrique prédéterminée ;
décollement du revêtement phosphoré (3) de la surface du substrat de silicium (1) ;
implantation thermique des atomes de phosphore dopant les domaines de dopage (5) afin de réaliser le domaine émetteur dopé n localement défini de la cellule solaire avec réalisation simultanée d'une couche d'oxyde (7) avec une épaisseur dans un intervalle allant de 5 nm à 100 nm sur la surface (la) ;
corrosion d'au moins une partie de l'épaisseur de la couche d'oxyde (7), dans lequel une partie de l'épaisseur de la couche d'oxyde (7) fermée est laissée à la passivation de surface, une partie uniquement de l'épaisseur de la couche d'oxyde (7) produite étant ôtée par corrosion ;
déposition d'une couche de SiNx (9, 9') sur le côté de la surface du substrat de silicium (1) prévue pour le domaine émetteur (la), dans lequel la couche de SiNx (9') est déposée sur la couche d'oxyde (7) laissée à la passivation de surface.

2. Procédé selon la revendication 1,
dans lequel le domaine émetteur est localement défini par commande des coordonnées du faisceau laser (L) par rapport à la surface du substrat de silicium.

3. Procédé selon la revendication 2,
dans lequel le domaine émetteur est défini localement comme structure en forme de doigt.

4. Procédé selon l'une des revendications 2 ou 3,
dans lequel la commande des coordonnées s'effectue en fonction de paramètres qui peuvent être extrapolés de la concentration en phosphore dans le revêtement phosphoré (3) et du profil de dopage désiré du domaine de dopage (5).

5. Procédé selon l'une des revendications précédentes,
dans lequel les domaines de dopage (5) localement définis sont produits conformément à une configuration géométrique prédéterminée d'un émetteur sélectif.

6. Procédé selon l'une des revendications précédentes,
dans lequel l'étape de l'implantation thermique des atomes de phosphore est mise en œuvre de telle sorte que le domaine de dopage produit est agrandi.

7. Procédé selon la revendication 6,
dans lequel le domaine de dopage produit par implantation thermique des atomes de phosphore est élargi latéralement.

8. Procédé selon l'une des revendications précédentes,
dans lequel le revêtement phosphoré est du verre de phosphosilicate.

9. Procédé selon l'une des revendications précédentes,
dans lequel le revêtement phosphoré est produit par un processus au POCl₃.
